(19) Europäisches Patentamt
European Patent Office
Office européen des brevets

(11) Publication number: **0 236 123**
**A2**

(12) # EUROPEAN PATENT APPLICATION

(21) Application number: **87301846.9**

(22) Date of filing: **03.03.87**

(51) Int. Cl.⁴: **H 01 L 21/28**
**H 01 L 21/00, H 01 L 21/306,**
**H 01 L 29/78**

(30) Priority: **04.03.86 JP 46718/86**
**07.03.86 JP 49758/86**
**09.05.86 JP 105959/86**
**23.01.87 JP 13437/87**

(43) Date of publication of application:
**09.09.87 Bulletin 87/37**

(84) Designated Contracting States: **DE FR GB NL**

(71) Applicant: **SEIKO EPSON CORPORATION**
**4-1, Nishishinjuku 2-chome**
**Shinjuku-ku Tokyo-to (JP)**

(72) Inventor: **Asahira, Michio**
**c/o SEIKO EPSON CORPORATION 3-5, Owa, 3-chome**
**Suwa-shi Nagano-ken (JP)**

**Goto, Makio**
**c/o SEIKO EPSON CORPORATION 3-5, Owa, 3-chome**
**Suwa-shi Nagano-ken (JP)**

(74) Representative: **Miller, Joseph et al**
**J. MILLER & CO. Lincoln House 296-302 High Holborn**
**London WC1V 7JH (GB)**

(54) A semiconductor device and method for preparing the same.

(57) A method of making a semiconductor device comprising forming a gate electrode (104a, 303a, 404) on a $ilicon semiconductor substrate (101,301,401) with a gate insulating film (103,302,403) therebetween, and forming a side wall insulating film (109,307,406) at the side walls of the gate electrode (104a, 303a, 404) characterised by etching the substrate (101,301,401) while using the gate electrode (104a 303a, 404), or any film (105,304) thereon, and the side wall insulating film (109,307,406) as a masking means so as to form a groove (111,301a, 407) in the substrate (101,301,401) immediately adjacent to the side wall insulating film (109,307,406).

Fig. 1(a)

**Description**

## "A SEMICONDUCTOR DEVICE AND METHOD FOR PREPARING THE SAME"

The present invention relates to a semiconductor device and a method for preparing the same.

According to the present invention, there is provided a method of making a semiconductor device comprising forming a gate electrode on a silicon semiconductor substrate with a gate insulating film therebetween, and forming a side wall insulating film at the side walls of the gate electrode, characterised by etching the substrate while using the gate electrode or any film thereon and the side wall insulating film as a masking means so as to form a groove in the substrate immediately adjacent to the side wall insulating film.

In the preferred form of the present invention, an improved semiconductor device is provided which includes a transistor and a capacitor, or an element isolating region in or on the semiconductor substrate. In the said preferred form, the gate electrode of the transistor is first formed and then a capacitor, an element isolating region and a contact hole are formed so that the room which must be provided for alignment of the gate electrode and the capacitor, the gate electrode and the element isolating region, and the gate electrode and the contact hole, is reduced. (This method of forming the elements using the previously formed element as a mask so that no additional process is necessary to align the elements at the desired position is referred to below as a "self-aligning process".). Thus, the present invention is particularly suitable for the miniaturization of a semiconductor device.

The present invention is further pertinent to a high-density and high-speed response semiconductor device in which diffusion capacity and resistance are greatly reduced.

In the prior art, when a field insulating film is formed by the selective oxidization of the substrate (generally called "LOCOS" = Local Oxidization of Silicon), it is necessary to form an anti-oxidization mask on the portion of the substrate which it is not desired to oxidize. Then, when the anti-oxidization mask is removed after the field insulating film has been formed, the end portion of the field insulating film protrudes to an undesirable extent. The projection of the end portion of the field insulating film constitutes the so-called "bird's beak" which causes defects such as disconnection of connectors formed in the later steps. The method of the present invention eliminates the "bird's beak" of the field oxide film, and is also advantageous for improving the response time of the device.

In a preferred form of the present invention, an element isolating insulating region is formed in the groove for separating the elements and a diffused region is formed on the element isolating insulating region so that the capacity of the diffusion to hinder a high-speed response is reduced to a minimum, thereby greatly reducing the RC delay.

In one form of the invention the method comprises forming an anti-anisotropic etching film on the gate electrode, the said anti-anisotropic etching film being adapted to mask silicon so that the masked silicon cannot be anisotropically etched, and forming a diffused region in said substrate by using said anti-anisotropic etching film as a mask.

The method preferably also comprises forming the said side wall insulating film on said substrate and on said anti-anisotropic etching film, selectively etching the side wall insulating film by an anisotropic etching process so that the latter film extends around the side walls only of the gate electrode, and etching the substrate to form the said groove while using the said anti-anisotropic etching film and said side wall insulating film as the said masking means.

The method may additionally comprise forming a capacitor oxide film in said groove by thermal oxidation, and forming on said capacitor oxide film a polycrystalline silicon layer so as to form a capacitor electrode in said groove.

In another form of the invention, the method comprises forming an element isolating insulating film in said groove so that a part of said substrate at the side of said groove and adjacent to the side wall insulating film is exposed; and introducing an impurity into said exposed part to form source and drain regions.

In this case, the method preferably also comprises forming an inter-layer insulating film on the entire surface of the device; forming a contact hole in said inter-layer insulating film; and forming a connector which is electrically connected to the source and drain regions through the contact hole.

The invention is illustrated, merely by way of example, in the accompanying drawings, in which:-

Figures 1(a) to 1(h) illustrate steps in a first embodiment of a method for manufacturing a semiconductor device in accordance with the present invention;

Figures 2(a) to 2(k) illustrate steps in a second embodiment of a method for manufacturing a semiconductor device in accordance with the present invention;

Figures 3(a) to 3(e) illustrate steps in a third embodiment of a method for manufacturing a semiconductor device in accordance with the present invention;

Figures 4(a) to 4(g) illustrate steps in a fourth embodiment of a method for manufacturing a semiconductor device in accordance with the present invention;

Figure 5 is a plan view of a semiconductor device manufactured by the method of Figure 4; and

Figure 6 is a sectional view of a semiconductor device previously known to the Applicants.

Terms such as "upper" and "lower", as used in the description below, are to be understood to refer to directions as seen in the accompanying drawings.

In the prior art, semiconductor devices, especially semiconductor memory devices including capacitors, have been generally formed by a method consisting of the steps of forming an element isolating region, forming a capacitor region by forming a groove or by a deposition process, and then forming a gate electrode and a contact hole.

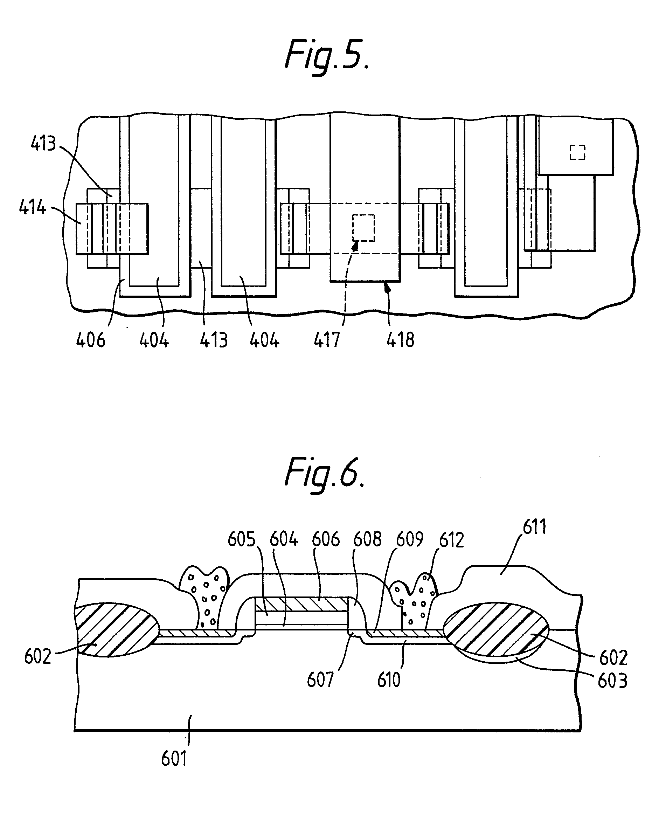

Reference is made to Figure 6 in which is shown a semiconductor device previously known to the Applicants. In the construction of Figure 6, an element isolating oxide film 602 is formed in a silicon substrate 601 by a known technique and a stopper region 603 is simultaneously formed.

After forming a gate oxide film 604 on the silicon substrate 601, and a gate electrode 605 of polysilicon on the gate oxide film 604, a low-density diffused region 607 is formed by using the gate electrode 605 as a mask. Then a side wall oxide film 608 is formed on the edges of the gate electrode 605. A film of Ti was then applied to the entire surface of the device to form portions 606 and 609 where the electrode and the diffused region are made into $TiSi_2$, respectively, by a self-aligning process. The impurity is diffused by ion inplanting and forms an interlayer insulating film 611. The device is then annealed to form source and drain diffused regions 610 under the $TiSi_2$. Contact holes are formed by contact etching and finally aluminium alloy connectors 612 are formed.

In the device shown in Figure 6, however, it is necessary to arrange that there is sufficient room for parts such as a capacitor, or an element isolating region, a gate electrode and a contact hole so that the gate electrode can be aligned with the capacitor, the element isolating region, and the contact hole. Consquently, the need to provide such room for alignment prevents the devicefrombeing miniaturized.

An object of the invention is therefore to provide an improved method of making a semiconductor device in which room for the alignment of the gate electrode and the capacitor, the alignment of the gate electrode and the element isolating region, and the alignment of the gate electrode and the contact hole is reduced, thereby providing a high-density semiconductor device.

In the embodiments of the present invention described below, however, the gate electrode is first formed and a capacitor and a contact hole or an element isolating region are formed by a self-aligning process using the gate electrode as a mask.

In the device of Figure 6, while the diffusion resistance is reduced, the diffusion capacity (the capacity between the substrate and the diffused region) is not reduced. In a large integrated circuit device, however, in which there are many diffusion connectors besides the source and the drain regions, the response speed is substantially decreased due to the diffusion capacity. Since the reduction of the total response speed of the device depends to a large extent upon the integrity and the miniaturization of the elements, a large "bird's beak" prevents the integration of elements.

In the embodiments of the present invention described below, however, factors which have affected the high-speed response of a semiconductor device in the prior art are eliminated. Namely, the gate electrode is first formed and an element isolating region is formed by a self-aligning process using the gate electrode as a mask so that the "bird's beak" is eliminated and then a diffused region is formed on the element isolating region. Thus, the capacity between the substrate and the diffused region is reduced to almost zero.

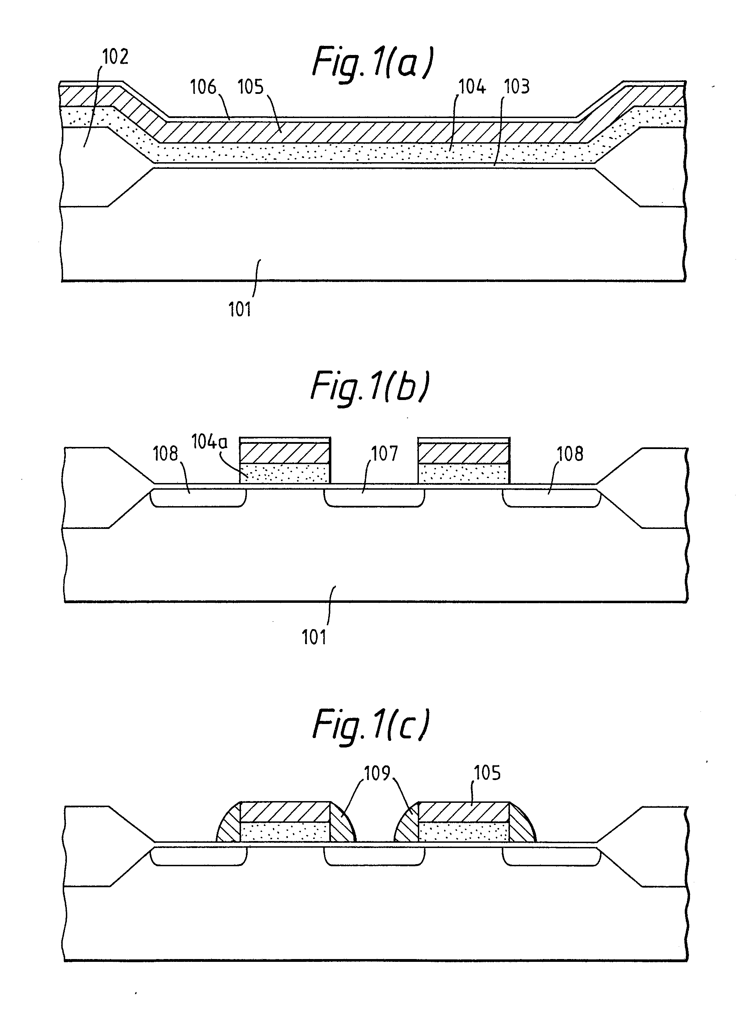

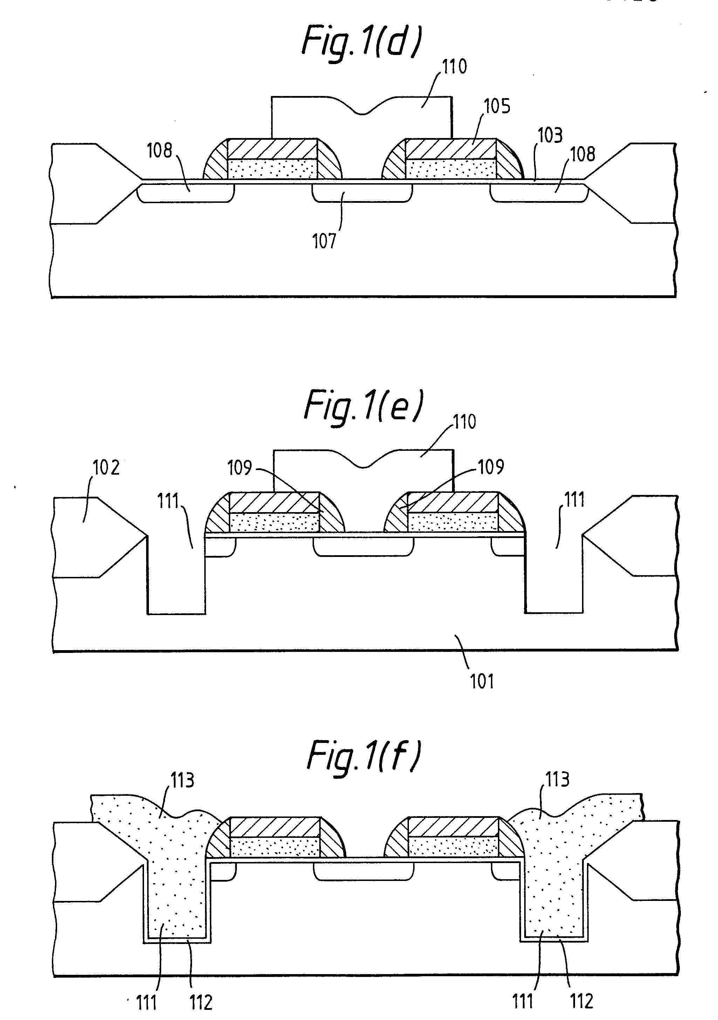

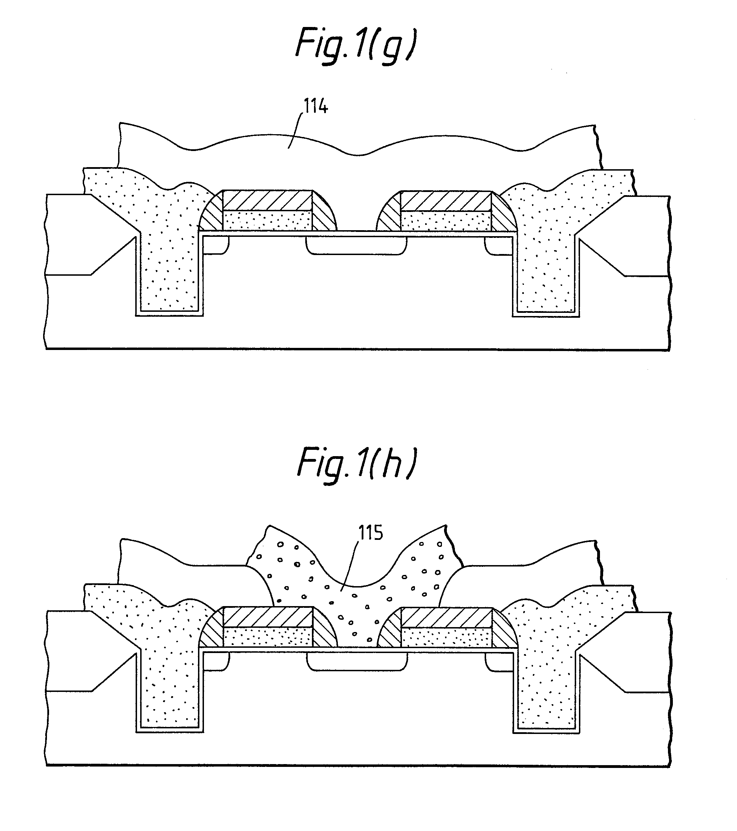

A first embodiment of a method for manufacturing a semiconductor device in accordance with the present invention is described below with reference to Figures 1(a) to (h).

Step 1 ... Figure 1(a)

First an element isolating oxide film 102 is formed on a P-type silicon semi-conductor substrate 101 and then a gate oxide film 103, which constitutes a gate insulating film, is formed by thermal oxidation of the substrate 101. On the gate oxide film 103 there is formed a first polycrystalline silicon film 104 having a thickness of between 2000 and 4000 Angstroms by a chemical vapour deposition step, and phosphorine is thermally diffused into the film 104 at a temperature between 800 and 1000°C. The film 104 constitutes a gate electrode film.

A first nitride film 105 is formed with a thickness of between 2000 and 4000 Angstroms on the film 104 by a chemical vapour deposition step, and a thermal oxide film 106 with a thickness of between 100 and 200 Angstroms is formed on the surface of the first nitride film 105 at a temperature of between 1000 and 1200°C. The first nitride film 105 constitutes an anti-anisotropic etching film which is adapted to mask silicon so that the masked silicon is not anisotropically etched.

Step 2....Figure 1(b)

Using a resist pattern (not shown) as a mask, the thermal oxide film 106 is selectively etched by an anisotropic or by an isotropic etching process to form gate electrode portions, and then, using the thermal oxide film 106 as a mask, the first nitride film 105 is etched by an anisotropic or by an isotropic etching process. Then using the first nitride film 105 as a mask, the first polycrystalline silicon film 104 is etched by an anisotropic or by an isotropic etching process and an N-type impurity is diffused into the substrate 101 by ion inplantation and the device is annealed to form N-type diffused regions 107 and 108. The etching of the first polycrystalline silicon film 104 produces the required gate electrodes 104a.

Step 3.....Figure 1(c).

A second nitride film, constituting an insulating film, is formed upon the entire surface of the device with a thickness of between 2000 and 4000 Angstroms by a chemical vapour deposition step and the whole surface of the second nitride film is etched by an anisotropic etching process with reactive ions to remove the thermal oxide film 106 and to form nitride side walls 109 of the gate electrodes 104a.

Step 4....Figure 1(d)

Masking the N-type diffused region 107 with a resist pattern 110, the gate oxide film 103 is selectively removed by using diluted hydrofluoric acid.

## Step 5....Figure 1(e)

Using the resist pattern 110, the element isolating oxide film 102, the first nitride film 105 and the nitride side walls 109 as a mask, the P-type semiconductor substrate 101 is anisotropically etched in a self-aligning manner, for example, with reactive ions (RIE), to a depth of between 3 and 5 microns to form grooved capacitor regions 111.

## Step 6....Figure 1(f)

After removing the resist pattern 110, the capacitor regions 111 are thermally oxidized to form a capacitor oxide film 112. Then a second polycrystalline silicon layer 113 is formed on the film 112 by a chemical vapour deposition step, and using a resist pattern mask, the second polycrystalline silicon layer 113 is etched to form capacitor electrodes.

## Step 7....Figure 1(g)

An interlayer insulating oxide film 114 is formed on the product so far produced by a chemical vapour deposition step with a thickness of between 3000 and 6000 Angstroms.

## Step 8....Figure 1(h)

Masking with a resist pattern, the interlayer insulating oxide film 114 is etched to form a contact hole, and the connector material 115 (e.g. of aluminium) is formed by sputtering.

According to the first embodiment of the present invention as described above, the capacitor and the contact hole are self-aligned with respect to the gate electrode, which has the advantage of substantially reducing the size of the device.

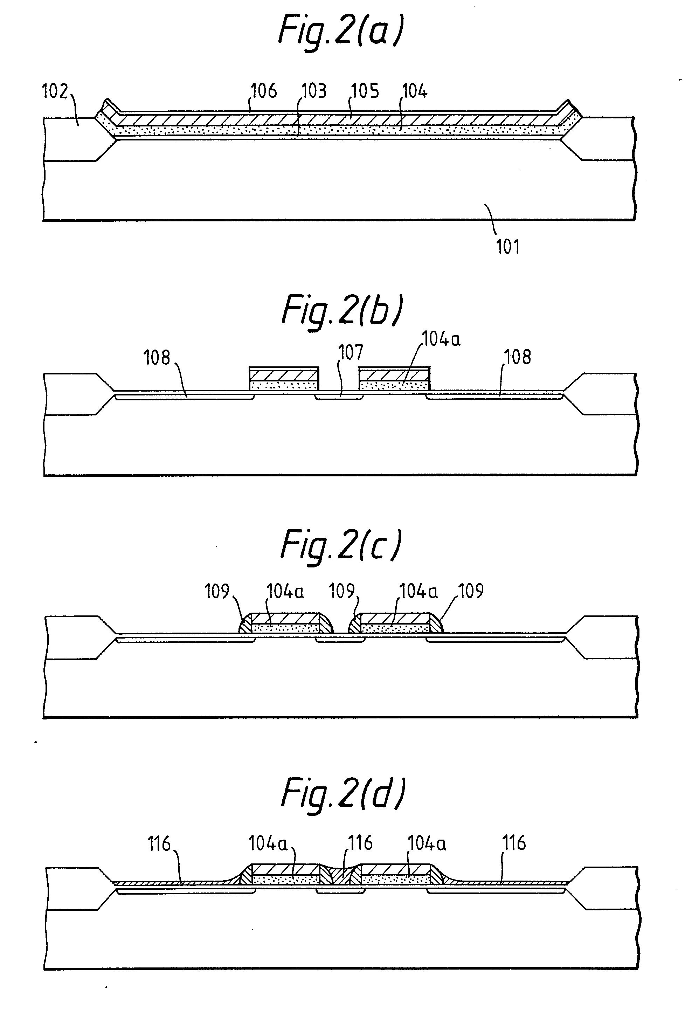

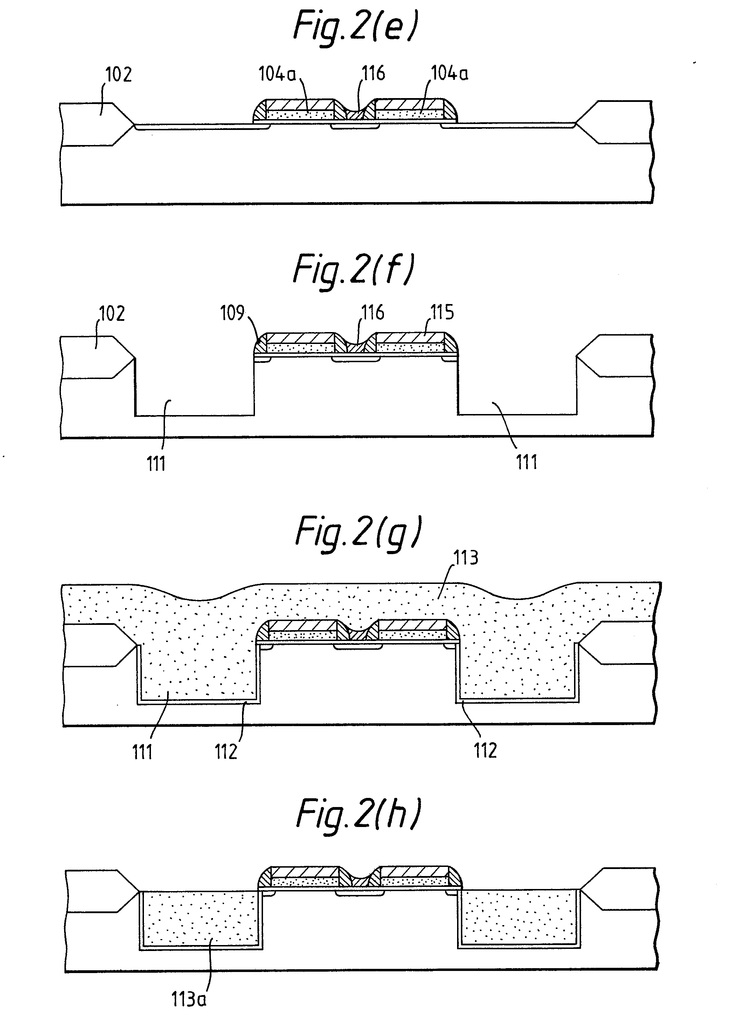

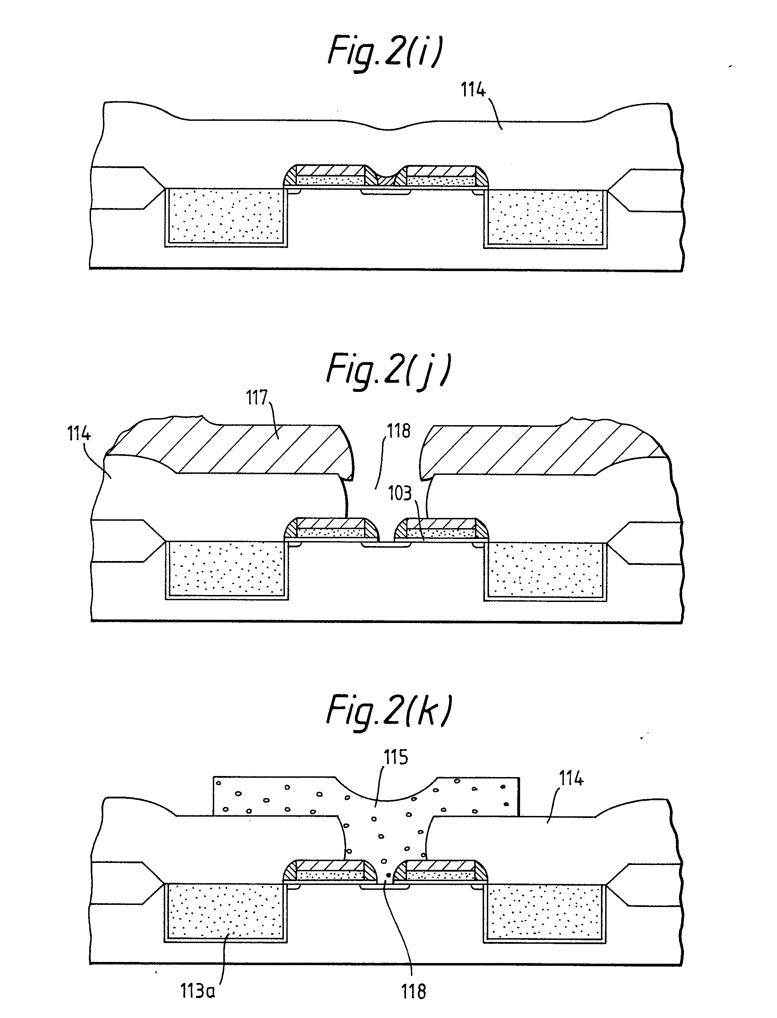

A second embodiment of the invention is described below with reference to Figures 2(a) to 2(k).

## Step 1.....Figure 2(a)

First an element isolating oxide film 102 is formed on a P-type semiconductor substrate 101 and a gate oxide film 103, which constitutes a gate insulating film, is formed by the thermal oxidization of thesubstrate 101, the gate oxide film 103 having a thickness of between 100 and 200 Angstroms. On the gate oxide film 103 is formed a first polycrystalline silicon film 104 by a chemical vapour deposition step, the film 104 having a thickness of between 1500 and 2500 Angstroms. The film 104 constitutes a gate electrode film. Phosphorine is thermally diffused into the film 104 at a temperature between 800 and 1000°C.

Then a first nitride film 105 is formed on the film 104 with a thickness of between 2000 and 4000 Angstroms by a chemical vapour deposition step, and a thermal oxide film 106 with a thickness of between 100 and 200 Angstroms is formed on the surface of the first nitride film 105 at a temperature of between 1000 and 1200°C. The first nitride film 105 constitutes an anti-anisotropic etching film which is adapted to mask silicon so that the masked silicon is not anisotropically etched.

## Step 2....Figure 2(b)

Masking with a resist pattern (not shown), the thermal oxide film 106 is selectively etched by an anisotropic or by an isotropic, etching process to form gate electrode portions, and using the thermal oxide film 106 as a mask, the first nitride film 105 is then etched by an anisotropic or by an isotropic etching process. Using the first nitride film 105 as a mask,the first polycrystalline siliconfilm 104 is etched by an anisotropic or by an isotropic etching process and an N-type impurity is diffused into the substrate 101 by ion inplantation and then the device is thermally annealed to form N-type diffused regions 107 and 108. The etching of the first polycrystalline silicon film 104 produces the required gate electrodes 104a.

## Step 3...Figure 2(c)

A second nitride film which constitutes an insulating film and which has a thickness of between 2000 and 4000 Angstroms, is formed on the entire surface of the device by a chemical vapour deposition step and the whole surface of the second nitride film is etched by an anisotropic etching process using reactive ions to remove the thermal oxide film 106 and to form nitride side walls 109 of the gate electrodes 104a.

## Step 4...Figure 2(d)

The entire surface of the device is then coated with a silica series coating film 116 by the spinning coating method. After baking the device by using a hot plate at a temperature between 100 and 200°C, the device is annealed in a nitride atmosphere at a temperature between 800 and 1000°C. (At this time, the silica series coating film 116 is thicker at the portions of the device where the patterns are dense than at other portions, which causes the differences of thickness shown in Figure 2(d)).

## Step 5....Figure 2(e)

The thickness of the silica series coating film 116 is reduced by the same amount throughout the whole extent of the film 116 with diluted hydrofluoric acid. (At this time, the silica series coating film 116 remains only at the portion between the gate electrodes 104a).

## Step 6 .... Figure 2(f)

Using the remaining silica series coating film 116, the element isolating oxide film 102, the first nitride film 105 and the nitride side walls 109 as masks, the P-type semiconductor substrate 101 is anisotropically etched in a self-aligning manner, for example with reactive ions (RIE), to a depth of between 3 and 5 microns to form grooved capacitor regions 111.

## Step 7....Figure 2(g)

The capacitor regions111are thermally oxidized to form a capacitor oxide film 112 having a thickness of between 100 and 200 Angstroms, and then a second polycrystalline silicon layer 113 having a thickness between and 6 microns is deposited on the film 112 by chemical vapor deposition.

Step 8....Figure 2(h)

The whole surface of the second polycrystalline silicon layer 113 is then anisotropically etched, for example with reactive ions (RIE), to form the capacitor electrodes 113a.

Step 9....Figure 2(i)

An interlayer insulating oxide film 114, having a thickness of between 3000 and 6000 Angstroms, is then formed over the device by chemical vapour deposition.

Step 10.....Figure 2(j)

Masking with a resist pattern 117, a selected part of the interlayer insulating oxide film 114, the silica series coating film 116 (not shown in Figure 2(j)) and a selected part of the gate oxide film 103 are etched to form a contact hole 118.

Step 11....Figure 2(k)

After removing the resist pattern 117, connector material 115 (e.g. of aluminium) is formed on the film 114 and in the contact hole 118 by, for example, sputtering.

In the second embodiment of the invention as described above, the capacitor electrodes 113a and the contact hole 118 are self-aligned with respect to the gate electrodes 104a, which greatly reduces the size of the device.

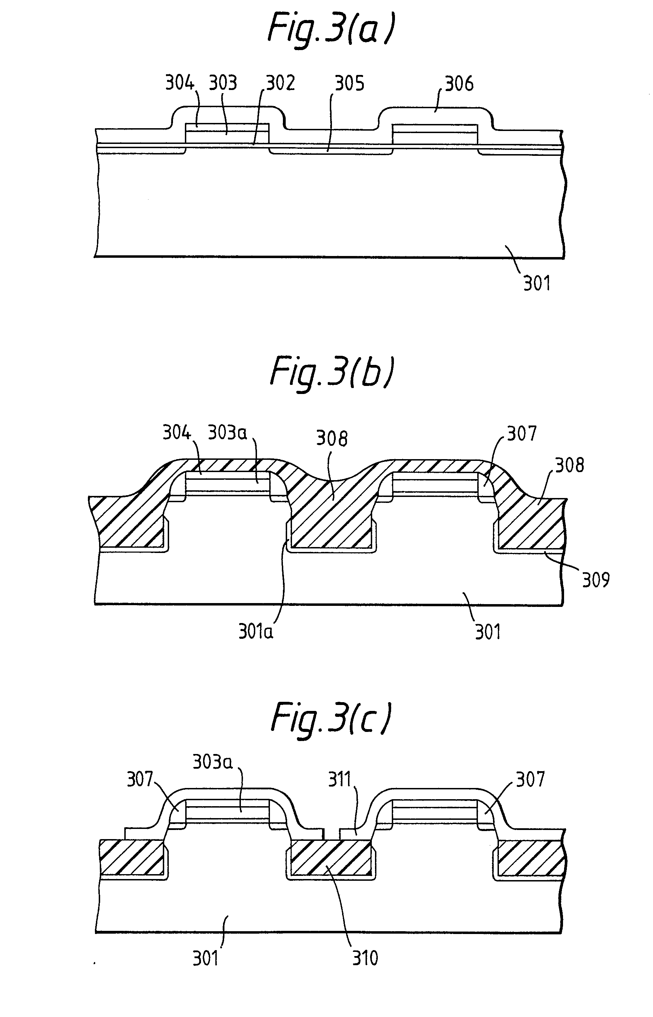

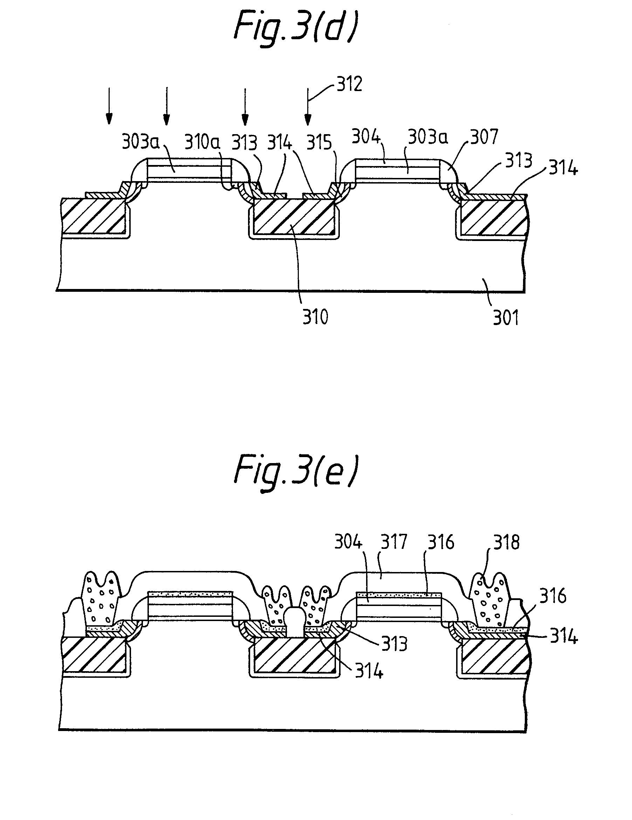

A third embodiment of the present invention is described below with reference to Figures 3(a) to 3(e).

Step 1.....Figure 3(a)

A gate oxide film 302, which constitutes a gate insulating film, is formed on a silicon semiconductor substrate 301 and has a thickness of 200 Angstroms. Then a gate electrode layer 303 is formed on the gate oxide film 302, the gate electrode layer 303 being a polycrystalline silicon layer doped with phosphorine and having a thickness of 1500 Angstroms. A molybdenumsilicide film 304 having a thickness of 2500 Angstroms is deposited on the gate electrode layer 303. The molybdenum silicide film 304 acts as an anti-anisotropic etching film adapted to mask silicon so that said masked silicon is not etched. The molybdenum silicide film 304 is patterned and etched by an anisotropic etching process to form gate electrodes 303a which have thus been masked by the molybdenum silicide film 304. Using the film 304 and the gate electrodes 303a as a mask, a low-density diffused region 305 is formed in the substrate 301 and a plasma nitride film 306 is formed over the whole device and has a thickness of 5000 Angstroms.

Step 2....Figure 3(b)

After masking by means of the gate electrodes 303a and the corresponding portions of the film 304, the nitride film 306 and thereafter the silicon substrate 301 are anisotropically etched, for example, with reactive ions (RIE), to a depth of 7000 Angstroms. This etching has the effect of forming side wall portions 307 at the sides of the gate electrodes 303a and grooved regions 301a, the side wall portions 307 acting as masks during the formation of the grooved regions 301a. Then a boron silicate glass (BSG) film 308 is formed over the whole device and has a thickness of 8000 Angstroms. The device is then annealed with a lamp at 1100°C for 30 seconds to cause flow of the BSG film 308 and to form a desired stopper 309 and an element isolating insulating film 310 in the grooved region 301a, so that a part 310a of the substrate 301 at the side of each groove 301a beneath the side wall portions 307 is exposed.

Step 3....Figure 3(c)

The BSG film 308 which has been so caused to flow is etched until the portions of the silicon substrate 301 beneath the side walls 307 are exposed and a Ti (titanium) layer 311 is deposited over the whole device. The Ti layer 311 is then selectively etched to form the regions which correspond to the source and drain regions 610 of Figure 6.

Step 4.......Figure 3(d)

By lamp-annealing the Ti layer 311, the silicon substrate 301 is made into a $TiS_2$ layer 313, and the Ti layer 311 on the element isolating insulating film 310 reacts with a part of the silicon $SiO_2$ in the boron silicate glass to form a thin $TixSiy$ layer 314, where x and y are integers. Since at the gate electrodes 303a and the side wall films 307, silicide is not produced, the Ti layer 311 is selectively etched and the source and the drain regions are formed therefrom on the element isolating film 310 and on the substrate 301.

By diffusing an impurity 312 by ion inplantation into the part 310a and by carrying out lamp-annealing, diffused regions 315 are formed in the substrate 301, the impurity 312 passing through the $Tisi_2$ film 314 in contact with the silicon substrate 301.

Step 5.....Figure 3(e)

A tungsten layer 316 is selectively formed on the $TiSi_2$ layer 313 and on the $MoSi_2$ electrodes 314 to separate the gate, the source and the drain regions. Thus, the resistance of the gate, source and drain is low.

Then an interlayer insulating film 317 of silicon dioxide is formed with a thickness of 2 microns under reduced pressure and aluminium connectors 318 are formed by contact etching of the film 317.

The connectors 318 are connected to the source and drain regions 315 and are disposed above the element isolating insulating film 310.

In the third embodiment of the invention, the diffused region is formed basically on the element isolating oxide film 310, in contrast to its being formed in the silicon substrate 601 in the Figure 6 construction. Furthermore, in the third embodiment, a semiconductor device of low resistance and which includes an element isolating film without a bird's beak is produced, and the elements of the device are formed by the self-aligning process using the gate electrodes 303a as a mask, which greatly reduces the diffusion capacity. Accordingly, high-density integration of the device is provided.

The diffused regions referred to in the description of the embodiments of the present invention also comprise connectors for extracting electric signals from the junction of the source and drain regions of the transistor.

In the third embodiment, the diffused regions can be arbitrarily connected and consequently the wiring used in the prior art is not necessary, which increases the integrity of the elements.

In the above description, the gate is formed of molybdenum polycide (a gate consisting of two layers of molybdenum and polycrystalline silicon). However, other materials such as polysilicon, metal and metal nitride can also be used. Moreover, the material for the diffused region is not limited to the one mentioned above. Furthermore, the elements can be isolated not only by chemical vapour deposition but also by thermal oxidization.

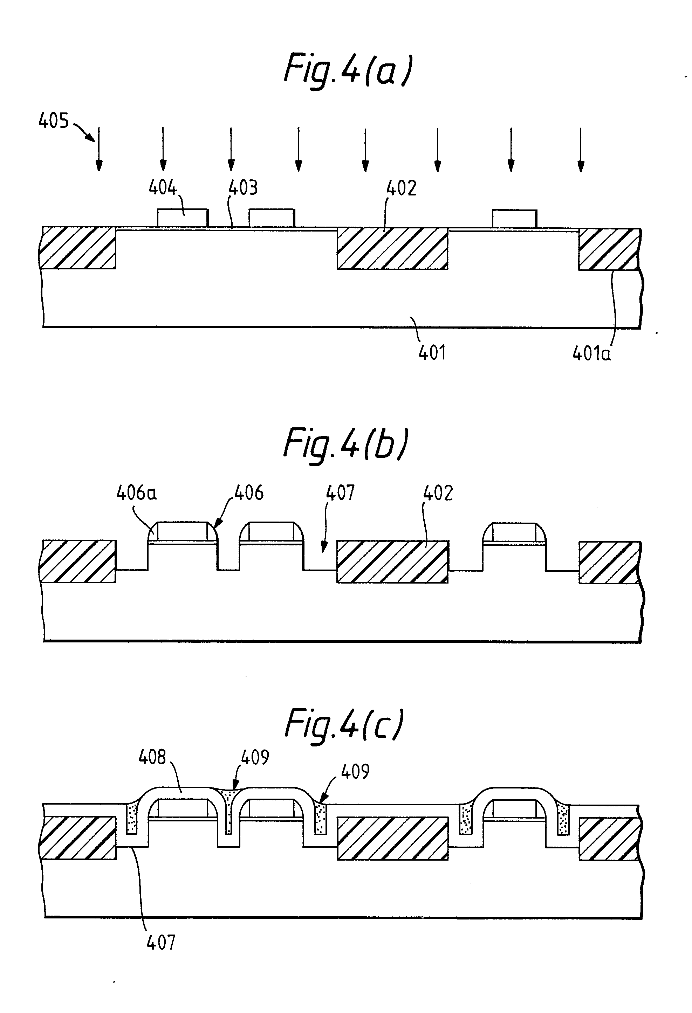

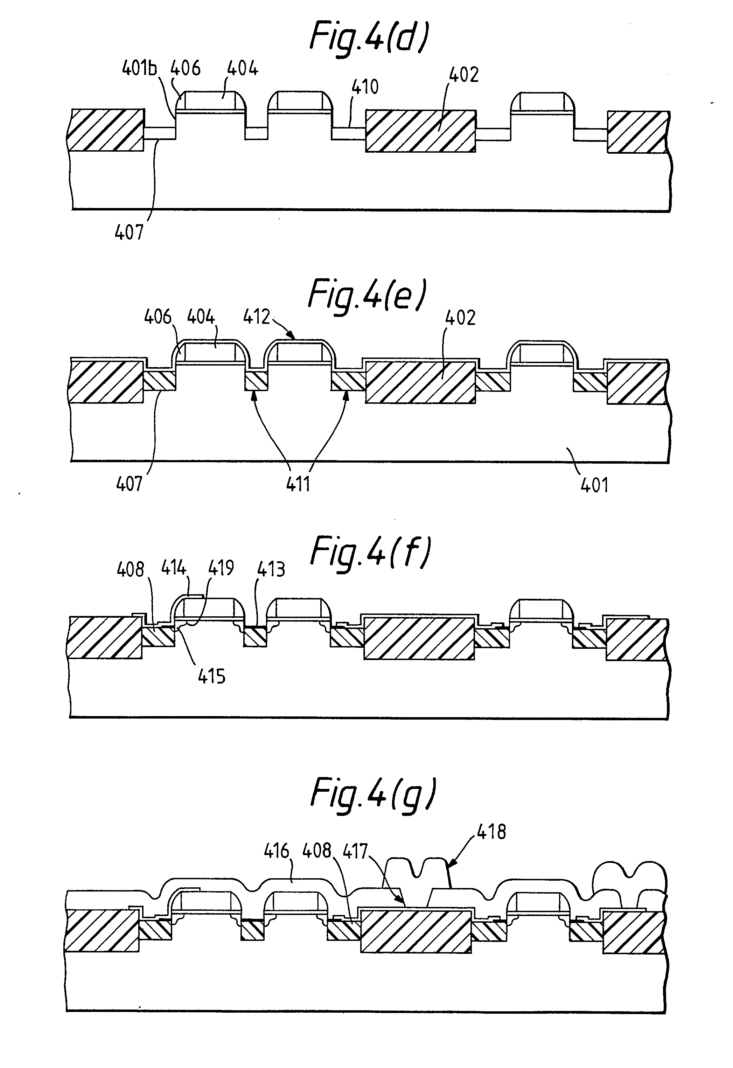

A fourth embodiment of the present invention is described below in detail with reference to Figures 4(a) to 4(g) and 5, indicating that different forms of the present invention are possible.

Step 1.....Figure 4(a)

A silicon substrate 401 is anisotropically etched, for example with reactive ions (RIE), to form grooves 401a. Then polycrystalline silicon is introduced into the grooves 401a and is oxidized to form an $SiO_2$ oxide layer 402 which constitutes an element isolating region as in the prior art.

Then a gate oxide film 403 which constitutes a gate insulating film and which has a thickness of 200 Angstroms is formed on the substrate 401 and gate electrodes 404 are formed by etching a W (tungsten) film having a thickness of 3000 Angstroms. Using the gate electrodes 404 as a mask, low-concentration P+ ions are inplanted for providing protection from hot electrons.

Step 2 .... Figure 4(b)

A side wall insulating $SiO2$ film 406 has portions 406a formed at the sides of the gate electrodes 404 by anisotropic etching such as RIE etching. Then using the side wall $SiO_2$ film 406, the gate electrodes 404 and the element isolating $SiO_2$ film 402 as a mask, the silicon substrate 401 is anisotropically etched, for example by RIE, to form grooves 407 having a depth of 7000 Angstroms, the grooves 407 being disposed at the side of and adjacent to the side wall insulating portions 406a.

Step 3 .... (figure 4(c)

A polycrystalline silicon layer 408 is formed over the entire surface of the device and has a thickness of 3000 Angstroms. Part of the layer 408 enters the grooves 407 to provide an element isolating insulating film therein. The surface of the polycrystalline silicon layer 408 is coated with a resist 409 having a thickness of 2 microns. The resist 409 is anisotropically etched selectively, for example, by $O_2$ RIE, to allow some resist 409 to remain in the grooves 407.

Step 4 .... Figure 4(d)

With such a structure, when the polycrystalline silicon layer 408 is anisotropically etched, for example by RIE, only the polycrystalline silicon portions 410 of the layer 408 which are disposed in the grooves 407 remain. This leaves parts 401b of the substrate 401 at the sides of the grooves 407 beneath the side wall portions 406 exposed.

Step 5 .... Figure 4(e)

By thermally oxidizing the polycrystalline silicon portions 410, $SiO_2$ portions 411 are formed which constitute element isolating regions. Thus this is equivalent to producing the $SiO_2$ portions 411 and the element isolating $SiO_2$ layer 402 by the use of a mask consisting of the gate electrodes 404, thereby forming the element isolating regions 402,411 by the self-aligning process.

The upper surfaces of the $SiO_2$ portions 411 at the sides of the side walls 406 should be a little lower than the upper surface of the gate oxide film 403. In other words, a part 401b of the silicon of the silicon substrate 401 at the lower portions of the side walls 406 is exposed. Over the surface of the whole device there is deposited a $TiSi_{2.5}$ (Ti:Si=2:5)/Ti double layer 412 having a thickness of 1000 Angstroms/ 6000 Angstroms respectively.

Step 6.....(Figure 4(f)

By lamp-annealing the device in an argon gas atmosphere at 740°C for 30 seconds, the portions 401b of the silicon substrate 401 beneath the side wall $SiO_2$ film 406 are changed into $TiSi_2$. At the same time, by annealing in an argon gas atmosphere, silicon is diffused in the lateral direction and the $TiSi_2$ extends to a depth of up to about 1 micron to form a $TiSi_2$ layer 413.

The layer 412 is not necessarily a double-layer of $TiSi_{2.5}$ and Ti since even the use of one single Ti film is effective.

Thus, the $TiSi_2$ layer 413 is divided into a gate region and drain and source regions. If the gate and drain or the drain and another drain are to be connected, the $TiSi_{2.5}$(Ti:Si=2:5)/Ti double layer 412 is selectively treated by the usual photolithography and the desired $TiSi_2$ portions 413 and $TiSi_{2.5}$ (Ti:S=2:5) portions 414 are formed by an etching process using $NH_4OH+H_2O_2$ series etching solution. Alternatively, if the distance between the gate electrodes 404 is short, the said regions may be connected by a $TiSi_2$ layer which extends laterally.

High concentration ions are inplanted from above the $TiSi_2$ layer 413 and the device is annealed at 1050°C for 20 seconds to form diffused regions 415 of the impurity extruded into the silicon from the $TiSi_2$ layer 413. At this time, a low concentration impurity 419 is also activated.

Step 7....Figure 4(g)

Then an inter-layer insulating film 416 of $SiO_2$, having a thickness of 6000 Angstroms is formed over the device. After forming contact holes 417 in the insulating film 416, aluminium connectors 418 are formed in the contact holes 417 so as to establish connection to the source and drain regions.

Figure 5 is a plan view of the device produced by the step shown in Figure 4(g). As shown in Figure 5, the carriers formed under the gate electrodes 404 are secured to junctions under the side wall $SiO_2$ film

406 and are connected to the outside through the TiSi₂ layer 413. The TiSi₂ portions 413 and the TiSi₂.₅(Ti:Si = 2:5) portions 414 are basically formed on the element isolation SiO₂ portions 411 which are selectively formed by using the gate electrodes 404 as a mask. Accordingly, since there is no diffused region and connector region in the silicon as in the prior art, the junction capacity is greatly reduced. Moreover, a semiconductor device of high integrity is thereby provided in accordance with the present invention.

In the third and fourth embodiments, the polarity of the silicon substrate and of the source and drain regions is not specified. But, necessarily, when the silicon substrate is P-type, the source and drain regions are N-type, and when the silicon substrate is N-type, the source and drain regions are P-type.

**Claims**

1. A method of making a semiconductor device comprising forming a gate electrode (104a, 303a, 404) on a silicon semiconductor substrate (101,301,401) with a gate insulating film (103,302,403) therebetween, and forming a side wall insulating film (109,307,406) at the side walls of the gate electrode (104a 303a, 404) characterised by etching the substrate (101,301,401) while using the gate electrode (104a, 303a, 404), or any film (105,304) thereon, and the side wall insulating film (109,307,406) as a masking means so as to form a groove (111,301a, 407) in the substrate (101,301,401) immediately adjacent to the side wall insulating film (109,307,406).

2. A method as claimed in claim 1 characterised by forming an anti-anisotropic etching film (105,304) on the gate electrode (104a, 303a), the said anti-anisotropic etching film (105,304) being adapted to mask silicon so that the masked silicon cannot be anisotropically etched, and forming a diffused region (107,305) in said substrate (101,301) by using said anti-anisotropic etching film (105,304) as a mask.

3. A method as claimed in claim 2 characterised by forming the said side wall insulating film (109,307) on said substrate (101,301) and on said anti-anisotropic etching film (105,304), selectively etching the side wall insulating film (109,307) by an anisotropic etching process so that the latter film (109,307) extends at the side walls only of the gate electrode (104a, 303a), and etching the substrate (101,301) to form the said groove (111,301a) while using the said anti-anisotropic etching film (105,304) and said side wall insulating film (109,307) as the said masking means.

4. A method as claimed in any preceding claim characterised by forming a capacitor oxide film (112) in said groove (111) by thermal oxidation, and forming on said capacitor oxide film (112) a polycrystalline silicon layer (113) so as to form a capacitor electrode in said groove (111).

5. A method as claimed in claim 1 characterised by forming an element isolating insulating film (408) in said groove (407) so that a part (401b) of said substrate (401) at the side of said groove (407) and adjacent to the side wall insulating film (406) is exposed; and introducing an impurity into said exposed part (401b) to form source and drain regions.

6. A method as claimed in claim 5 characterised by forming an inter-layer insulating film (416) on the entire surface of the device; forming a contact hole (417) in said inter-layer insulating film (416); and forming a connector (418) which is electrically connected to the source and drain regions through the contact hole (417).

7. A method of making a semiconductor device comprising the steps of:
   forming a gate insulating film (103,302) on a semiconductor substrate (101,301);
   forming a silicon gate electrode film (104,303) on said gate insulating film (103,302);
   forming an anti-anisotropic etching film (105,304) on said gate electrode film (104,303), said anti-anisotropic etching film (105,304) being adapted for masking silicon so that said masked silicon is not anisotropically etched;
   forming a diffused region (107,305) in said substrate (101,301) and forming a gate electrode (104a, 303a) using said anti-anisotropic etching film (105,304) as a mask;
   forming a first insulating film (109,306) on said substrate and on said anti-anisotropic etching film (105,304);
   selectively etching said first insulating film (109,306) by an anisotropic etching process to form a side wall insulating film at the sides of said gate electrode (104a, 303a); and
   etching said substrate (101,301) using said anti-anisotropic etching film (105,304) and said side wall insulating film (109,307) as a mask in a self-aligning manner to form a groove (111) in said substrate (101).

8. A semiconductor device comprising:
   a semiconductor substrate (401);
   a gate insulating film (403) formed on said substrate (401);
   a gate electrode (404) formed on said gate insulating film (403);
   a side wall insulating film (406) formed at the side walls of said gate electrode (404);
   a groove (407) formed in said semiconductor substrate (401) at the side of said side wall insulating film (406);
   an element isolating insulating film (408) formed in said groove (407) so that a part (401b) of the semiconductor substrate (401) at the upper portion of the side portion of said groove is exposed;
   source and a drain regions (401b) formed in said semiconductor substrate (401) at the exposed side portion of said groove beneath said side wall insulating film;

connectors (413,414) formed from said source and drain regions which extend over said element isolating insulating film (408);

an inter-layer insulating film (416) formed on said semiconductor substrate (401) including said gate electrode (404) and said side wall insulating film (406) and on said element isolating insulating film (408) including said connectors (413,414) from said source and drain regions;

a contact hole (417) formed in said inter-layer insulating film (416); and

a further connector (418) electrically connected to said connectors (413,414) from said source and drain regions (401b), said further connector (418) extending through said contact hole (417).

*Fig.1(a)*

102
106 105 104 103
101

*Fig.1(b)*

108 104a 107 108
101

*Fig.1(c)*

109 105

## Fig.1(d)

## Fig.1(e)

## Fig.1(f)

*Fig.1(g)*

114

*Fig.1(h)*

115

## *Fig.2(a)*

102 106 103 105 104

101

## *Fig.2(b)*

108 107 104a 108

## *Fig.2(c)*

109 104a 109 104a 109

## *Fig.2(d)*

116 104a 116 104a 116

*Fig.2(e)*

102    104a    116    104a

*Fig.2(f)*

102    109    116    115

111    111

*Fig.2(g)*

113

111    112    112

*Fig.2(h)*

113a

0236123

## Fig.2(i)

## Fig.2(j)

## Fig.2(k)

## Fig.3(a)

## Fig.3(b)

## Fig.3(c)

## Fig.3(d)

## Fig.3(e)

## Fig.4(a)

## Fig.4(b)

## Fig.4(c)

### Fig.4(d)

401b  406  404  410  402

407

### Fig.4(e)

406  404  412  402

407  411  401

### Fig.4(f)

408  414  419  413

415

### Fig.4(g)

416  408  417  418

## Fig.5.

413
414
406   404   413   404   417   418

## Fig.6.

605  604  606  608  609  612      611
602
607    610
602
603
601